# EUROPEAN PATENT APPLICATION

(11) **EP 3 176 194 A1**
(43) Date of publication of application: **07.06.2017**
(21) Application number: 15828114.7
(22) Date of filing: 30.07.2015
(51) Int. Cl.: C08F 299/06, C03C 15/00, C08F 290/06, C09D 109/00, C09K 13/08, G03F 7/027

(54) **COMPOSITION FOR FORMING RESIN THIN FILM FOR HYDROFLUORIC ACID ETCHING AND RESIN THIN FILM FOR HYDROFLUORIC ACID ETCHING**

(30) Priority: 30.07.2014 JP 2014155238
(71) Applicant: Nissan Chemical Industries, Ltd., Chiyoda-ku Tokyo 101-0054 (JP)
(72) Inventor: SATO, Tetsuo, Funabashi-shi Chiba 274-0052 (JP)
(74) Representative: Hoffmann Eitle
(86) International application number: PCT/JP2015/071663
(87) International publication number: WO 2016/017762

(57) **Abstract**

The invention provides a resin-thin-film-forming composition employed in hydrofluoric acid etching, which composition contains a hydrogenated polybutadiene compound having a (meth)acrylic group and a radical polymerization initiator.

## Description

### Technical Field

The present invention relates to a composition for forming a resin thin film employed in etching a substrate with hydrofluoric acid (hereinafter may be referred to as a "resin-thin-film-forming composition employed in hydrofluoric acid etching") and to a resin thin film for use in etching a substrate with hydrofluoric acid (hereinafter may be referred to as a "resin thin film for use in hydrofluoric acid etching").

### Background Art

Wet etching is a widely employed technique of processing a substrate and is carried out in various steps involved in processing large-scale substrates of flat-panel displays.

For example, in production of a back cap panel of an organic electroluminescence display (organic ELD), efforts have been made toward reduction in thickness of the ELD panel by employing a glass back cap panel. The back glass cap is formed through etching a glass substrate. In the etching process, a resist film is formed on the glass substrate, and only a region of interest is treated through etching.

Hitherto, a variety of resist resin compositions have been employed as a mask material for use in wet etching. Such a resist resin composition is applied onto a glass substrate or a substrate having an insulating film (e.g., SiO₂ or SiN) and patterned. Thereafter, the substrate is immersed, for etching, in an etching liquid (hereinafter may be referred to as an "etchant") containing, for example, hydrofluoric acid (HF).

However, among various acids, hydrofluoric acid has high permeability. Thus, difficulty is encountered in producing a film having a hydrofluoric acid barrier property. In this connection, several patent applications relating to hydrofluoric acid-resistant resists for glass etching were previously filed. The subjects of these patent applications include imparting a gas-barrier property to a resist through addition of a filler thereto (see, for example, Patent Documents 1 and 2), a composition containing an alkalisoluble resin and an acrylic monomer (see, for example, Patent Documents 3 to 7), and an aromatic polyarylate resin (e.g., Patent Document 8).

Also, in the case where adhesion between a substrate and a resist film is poor, the resist film is peeled from the substrate, and the amount of side etching increases, resulting in impairment of etching precision, which is problematic. In addition, when etching for a long time is required, pinholes are provided in the resist film, or a resist coating swells, resulting in peeling of the resist film from the substrate, which is problematic. In the case where a silane coupling agent has been incorporated into a resist film for enhancing adhesion, the silane coupling agent remains on the substrate after removal of the resist film. The remaining silane coupling agent problematically contaminates the substrate. However, there has been no case in which use of a silane coupling agent is avoided by use of an adhesive.

The mask material made of a resist resin composition is removed from the substrate after etching, through washing with a remover liquid or through peeling by hand. In order to ensure adhesion between the resist resin composition and the substrate, in some cases, an acrylic adhesive is used. Generally, an acrylic adhesive is known to have high susceptibility to hydrochloric acid and sulfuric acid contained in an etching liquid or the like; i.e., to have intrinsically low acid resistance. In order to overcome the drawback, there have been proposed a technique in which a radiation-curable adhesive is applied onto a radiation-transmitting film substrate having acid resistance, in order to enhance acid resistance (see, for example, Patent Document 9); a technique in which an adhesive is hydrophobicized by use of a C8 acrylate ester (see, for example, Patent Document 10); a technique in which an adhesive containing as a predominant component a monomer having a C≥6 alkyl group is used (see, for example, Patent Document 11); and other techniques. However, no acrylic adhesive has been verified to have hydrofluoric acid resistance, and there has not been reported use of an acrylic adhesive in a resin composition for etching with hydrofluoric acid.

### Prior Art Documents

### Patent Documents

Patent Document 1: Japanese Patent Application Laid-Open (*kokai*) No. 2005-164877
Patent Document 2: Japanese Patent Application Laid-Open (*kokai*) No. 2007-128052
Patent Document 3: Japanese Patent Application Laid-Open (*kokai*) No. 2010-72518
Patent Document 4: Japanese Patent Application Laid-Open (*kokai*) No. 2008-233346
Patent Document 5: Japanese Patent Application Laid-Open (*kokai*) No. 2008-76768
Patent Document 6: Japanese Patent Application Laid-Open (*kokai*) No. 2009-163080
Patent Document 7: Japanese Patent Application Laid-Open (*kokai*) No. 2006-337670
Patent Document 8: Japanese Patent Application Laid-Open (*kokai*) No. 2010-256788
Patent Document 9: Japanese Patent Application Laid-Open (*kokai*) No. Hei 5-195255
Patent Document 10: Japanese Patent Application Laid-Open (*kokai*) No. Hei 9-134991
Patent Document 11: Japanese Patent Application Laid-Open (*kokai*) No. 2013-40323

### Summary of the Invention

### Problems to be Solved by the Invention

In view of the foregoing, an object of the present invention is to provide a composition that can provide a thin resin film suitably serving as a resist film in etching of a glass substrate or a substrate having an insulating film (e.g., SiO₂ or SiN) with hydrofluoric acid.

### Means for Solving the Problems

Accordingly, the present inventor has conducted extensive studies to attain the aforementioned object, and has found that a resin thin film which is suitably serving as a resist film in etching a substrate with hydrofluoric acid can be obtained by use of a composition containing a hydrogenated polybutadiene compound having a (meth)acrylic group, and a radical polymerization initiator. The present invention has been accomplished on the basis of this finding.

Accordingly, the present invention provides the following.
1. A resin-thin-film-forming composition employed in hydrofluoric acid etching, which composition comprises a hydrogenated polybutadiene compound having a (meth)acrylic group and a radical polymerization initiator.
2. A resin-thin-film-forming composition according to 1 above and employed in hydrofluoric acid etching, wherein, in the hydrogenated polybutadiene compound having a (meth)acrylic group, the (meth)acrylic group is bonded via urethane bonding.
3. A resin thin film for use in hydrofluoric acid etching produced by use of a resin-thin-film-forming composition as recited in 1 or 2 above.
4. A method for producing a patterned substrate, characterized in that the method comprises a step of forming a resin thin film for use in hydrofluoric acid etching on a substrate by use of a resin-thin-film-forming composition employed in hydrofluoric acid etching as recited in 1 or 2 above; a step of curing the resin thin film; and a step of patterning, through etching, the substrate on which the resin thin film for use in hydrofluoric acid etching has been formed.

### Effects of the Invention

The resin thin film obtained from the composition of the present invention, after curing, exhibits sufficient resistance to an etchant containing hydrofluoric acid, and has sufficient adhesion to such a substrate, even when a silane coupling agent, which generates residual matter on the substrate, is not used. Thus, the resin film of the present invention is resistive against side etching during wet etching and cannot be readily peeled from the substrate during a long-term etching process. In addition, the thin film can be readily removed from the substrate and has excellent water resistance by virtue of not swelling with water.

Thus, by use of the resin composition of the present invention, there can be readily realized high-precision pattern formation on a glass substrate or a substrate having an insulating film (e.g., SiO₂ or SiN), whereby a glass substrate or the like having a pattern of interest can be readily produced.

### Modes for carrying Out the Invention

The resin-thin-film-forming composition of the present invention employed in hydrofluoric acid etching (hereinafter may be referred to simply as "composition") contains a hydrogenated polybutadiene compound having a (meth)acrylic group.

No particular limitation is imposed on the hydrogenated polybutadiene compound having a (meth)acrylic group employed in the present invention. A commercial product thereof or such a compound produced through a known method may also be used. However, in order to form, with high reproducibility, a thin film having a suitable strength and adhesion to a substrate, a hydrogenated polybutadiene compound having a (meth)acrylic group via a urethane bond is preferred.

An example of the hydrogenated polybutadiene compound which may be used in the invention is a reaction product obtained from a hydrogenated polybutadiene-polyol compound, a polyisocyanate compound, and a (meth)acrylate compound having a hydroxyl group (hereinafter may be referred to as a "hydroxyl group-containing (meth)acrylate compound").

Specific examples of the hydrogenated polybutadiene-polyol compound include compounds each having two or more hydroxyl groups and having a structure in which unsaturated bonds of a 1,4-polybutadiene, a 1,2-polybutadiene, or a 1,4-/1,2-polybutadiene are hydrogenated.

In order to suitably meet requirements for attaining uniform film properties from a uniform target reaction product and ensuring suitable hardness of the formed thin film, the hydrogenated polybutadiene-polyol compound preferably has two hydroxyl groups, and two hydroxyl groups are preferably located at both ends of the polybutadiene chain.

No particular limitation is imposed on the weight average molecular weight of the hydrogenated polybutadiene-polyol compound, and the molecular weight is generally about 300 to about 30,000.

From the viewpoint of attaining enhanced acid resistance of the thin film, the lower limit of the weight average molecular weight is preferably 500, more preferably 750, still more preferably 1,000. The upper limit thereof is preferably 20,000, more preferably 15,000, still more preferably 6,000, yet more preferably 3,000, in order to suppress an excessive rise of the viscosity of the composition to thereby ensure suitable workability.

Notably, the above weight average molecular weight is a weight average molecular weight as reduced to the molecular weight of a standard polystyrene. The weight average molecular weight is determined through high-performance liquid chromatography (Shodex GPC system-11, product of Showa Denko K.K.) by use of serially connected three columns (Shodex GPC KF-806L (product of Showa Denko K.K., elimination limit molecule quantity: 2×10⁷, separation range: 100 to 2×10⁷, theoretical plate no.: 10,000 steps/column, filler material: styrene-divinylbenzene copolymer, and filler particle size: 10 µm) (hereinafter, the same means being applied).

The hydrogenated polybutadiene-polyol compound generally has an iodine value of 0 to 50, preferably 0 to 20. The hydroxyl value thereof is generally 15 to 400 mgKOH/g, preferably 30 to 250 mgKOH/g.

The hydrogenated polybutadiene-polyol compound of the invention may be a synthetic product obtained through a known method. Specific examples include commercial products thereof such as NISSO PB (GI series, products of Nippon Soda Co. Ltd.), and Polytail H and HA (products of Mitsubish Chemical Co., Ltd.).

These polybutadiene-polyol compounds may be used singly or in combination of two or more species.

The polyisocyanate compound employed in the present invention may be an aromatic, an aliphatic, or an alicyclic polyisocyanate, or the like.

Specific examples thereof include diisocyanates such as tolylene diisocyanate, diphenylmethane diisocyanate, hydrogenated diphenylmethane diisocyanate, modified diphenylmethane diisocyanate, hydrogenated xylylene diisocyanate, xylylene diisocyanate, hexamethylene diisocyanate, trimethylhexamethylene diisocyanate, tetramethylxylylene diisocyanate, isophorone diisocyanate, norbornene diisocyanate, 1,3-bis(isocyanatomethyl)cyclohexane, benzene diisocyanate, naphthalene diisocyanate, and anthracene diisocyanate; trimers thereof; and biuret-type polyisocyanates thereof.

Of these, aromatic diisocyanates are preferred, with benzene diisocyanate being more preferred.

The molecular weight of the polyisocyanate compound is suitably 150 to 700, from the viewpoint of solubility.

The polyisocyanate compound used in the invention may be a synthetic product obtained through a known method or a commercial product.

These polyisocyanate compounds may be used singly or in combination of two or more species.

An example of the hydroxyl group-containing (meth)acrylate compound which may be used in the invention is a hydroxyalkyl (meth)acrylate. In order to attain high hydrofluoric acid resistance of the thin film and suitable adhesion to a substrate, the hydroxyalkyl group preferably has 1 to 20 carbon atoms, more preferably 2 to 10 carbon atoms, still more preferably 2 to 6 carbon atoms.

Specific examples of the hydroxyl group-containing (meth)acrylate compound include 2-hydroxyethyl (meth)acrylate, 2-hydroxypropyl (meth)acrylate, 2-hydroxybutyl (meth)acrylate, 2-(meth)acryloyloxyethyl dihydrogen phosphate, 4-hydroxybutyl (meth)acrylate, 2-(meth)acryloyloxyethyl(2-hydroxypropyl) phthalate, glycerin di(meth)acrylate, 2-hydroxy-3-(meth)acryloyloxypropyl (meth)acrylate, pentaerythritol tri(meth)acrylate, dipentaerythritol penta(meth)acrylate, and caprolactone-modified 2-hydroxyethyl (meth)acrylate.

The hydroxyl group-containing (meth)acrylate compound used in the invention may be a synthetic product obtained through a known method or a commercial product.

These hydroxyl group-containing (meth)acrylate compound may be used singly or in combination of two or more species.

An example of the hydrogenated polybutadiene compound having a (meth)acrylic group which may be used in the invention is a reaction product obtained from a hydrogenated polybutadiene-polyol compound and a (meth)acrylate compound having an isocyanate group (hereinafter may be referred to as an "isocyanate group-containing (meth)acrylate compound").

Examples of the hydrogenated polybutadiene-polyol compound are the same as described above.

An example of the isocyanate group-containing (meth)acrylate compound which may be used in the invention is an isocyanatoalkyl (meth)acrylate. In order to consistently attain high hydrofluoric acid resistance of the thin film and suitable adhesion to a substrate, the isocyanatoalkyl group preferably has 1 to 20 carbon atoms, more preferably 2 to 10 carbon atoms, still more preferably 2 to 6 carbon atoms.

Specific examples of the isocyanate group-containing (meth)acrylate compound include 2-isocyanatoethyl (meth)acrylate, 2-isocyanatopropyl (meth)acrylate, 2-isocyanatobutyl (meth)acrylate, and 4-isocyanatobutyl (meth)acrylate.

The isocyanate group-containing (meth)acrylate compound used in the invention may be a synthetic product obtained through a known method or a commercial product.

These isocyanate group-containing (meth)acrylate compound may be used singly or in combination of two or more species.

The reaction for yielding a product from a hydrogenated polybutadiene-polyol compound, a polyisocyanate compound, and a hydroxyl group-containing (meth)acrylate compound may be performed in a two-stage manner, in order to form an appropriate reaction product.

In one possible mode of the reaction, a hydrogenated polybutadiene-polyol compound is reacted with a polyisocyanate compound, to thereby yield a reaction intermediate having an unreacted isocyanate group, and the reaction intermediate is then reacted with a hydroxyl group-containing (meth)acrylate compound. In another possible mode of the reaction, a hydroxyl group-containing (meth)acrylate compound is reacted with a polyisocyanate compound, to thereby yield a reaction intermediate having an unreacted isocyanate group, and the reaction intermediate is then reacted with a hydrogenated polybutadiene-polyol compound.

In the two-stage production, the reaction intermediate may be isolated from the reaction system, and a hydroxyl group-containing (meth)acrylate compound or a hydrogenated polybutadiene-polyol compound may be dissolved in a solution of the intermediate. Alternatively, these compounds may be dissolved in a reaction mixture in which the intermediate has not been isolated.

The reaction for yielding a product from a hydrogenated polybutadiene-polyol compound, a polyisocyanate compound, and a hydroxyl group-containing (meth)acrylate compound is preferably performed in a solvent under inert gas (e.g., nitrogen), for carrying out the reaction under suitable conditions.

No particular limitation is imposed on the reaction solvent, so long as it is inert to the reaction. Examples of the solvent include hydrocarbons such as hexane, cyclohexane, benzene, and toluene; halo-hydrocarbons such as tetrachlorocarbon, chloroform, and 1,2-dichloroethane; ethers such as diethyl ether, diisopropyl ether, benzyl ethyl ether, dihexyl ether, 1,4-dioxane, and tetrahydrofuran; ketones such as acetone, methyl ethyl ketone, methyl isobutyl ketone, cyclohexanone (CHN), acetonylacetone, isophorone, and diacetone alcohol; nitriles such as acetonitrile and propionitrile; carboxylate esters such as ethyl acetate, ethyl propionate, benzyl acetate, ethyl benzoate, diethyl oxalate, and diethyl maleate; azo aprotic polar solvents such as N-methylformamide, N-methylformanilide, N-methylacetamide, N,N-dimethylformamide, N,N-dimethylacetamide, N-methyl-2-pyrrolidone, and 1,3-dimethyl-2-imidazolidinone; and sulfo aprotic polar solvents such as dimethylsulfoxide and sulfolane. Among them, toluene, cyclohexanone, etc. are preferred, since these solvents can sufficiently solve the starting materials of the reaction and is inert to the materials. These solvents may be used singly or in combination of two or more species.

The amounts of the hydrogenated polybutadiene-polyol compound, the polyisocyanate compound, and the hydroxyl group-containing (meth)acrylate compound used in the reaction cannot unequivocally be predetermined, since at least the number of hydroxyl groups of the hydrogenated polybutadiene-polyol compound, the number of isocyanate groups of the polyisocyanate compound, and employment of multi-stage reaction in the production vary. In a two-stage procedure, in which a hydrogenated polybutadiene diol compound, a diisocyanate compound, and a hydroxyl group-containing (meth)acrylate compound are used, to thereby yield a target reaction product, about 1 (relative amount of substance) of a hydrogenated polybutadiene diol compound is reacted with about 2 (relative amount of substance) of a diisocyanate compound, to thereby form a reaction intermediate, and about 1 (relative amount of substance) of the reaction intermediate is then reacted with about 2 (relative amount of substance) of a hydroxyl group-containing (meth)acrylate compound. Alternatively, about 1 (relative amount of substance) of a hydroxyl group-containing (meth)acrylate compound is reacted with about 1 (relative amount of substance) of a diisocyanate compound, to thereby form a reaction intermediate, and about 1 (relative amount of substance) of the reaction intermediate is then reacted with about 0.5 (relative amount of substance) of a hydrogenated polybutadiene diol compound.

Also, a catalyst may be used for promoting the reaction. Specific examples of the catalyst include organometallic compounds such as dibutyltin dilaurate, trimethyltin hydroxide, and tetra-n-butyltin; metal salts such as zinc octoate, tin octoate, cobalt naphthenate, stannous chloride, and stannic chloride; and amines such as pyridine, triethylamine, benzyldiethylamine, 1,4-diazabicyclo[2.2.2]octane, 1,8-diazabicyclo[5.4.0]-7-undecene, 1,5-diazebicyclo[4.3.0]-5-nonane, N,N,N',N'-tetramethyl-1,3-butanediamine, and N-ethylmorpholine.

Among them, dibutyltin dilaurate is preferred for effectively promoting formation of a urethane bond, and pyridine and 1,8-diazabicyclo[5.4.0]-7-undecene are preferred for effectively promoting formation of an ester bond.

The amount of the catalyst cannot unequivocally be predetermined, since it varies depending on the amounts of the solvent and starting compounds, etc. However, the catalyst amount is 0.00001 to 5 parts by mass, with respect to 100 parts by mass of the hydrogenated polybutadiene-polyol compound (or a reaction intermediate).

The starting compound concentration cannot unequivocally be predetermined, since it varies depending on the types of the solvent and starting compounds, etc. In the case where a solvent is employed in the reaction, the concentration is appropriately predetermined so as to fall within a range of 0.1 to 100 mass% with respect to the solvent.

Also, the reaction time and temperature cannot unequivocally be predetermined, since they vary depending on the types of the solvent and starting compounds, etc. Generally, the reaction time and temperature are appropriately predetermined so as to fall within ranges of 20 to 100°C and 5 minutes to 100 hours.

The reaction for yielding a product from a hydrogenated polybutadiene-polyol compound and an isocyanate group-containing (meth)acrylate compound is preferably performed in a solvent under inert gas (e.g., nitrogen), for carrying out the reaction under suitable conditions. If needed, a catalyst may be used. Specific examples of the solvent and the catalyst, and conditions of amounts thereof and the like are the same as described above.

The amounts of the hydrogenated polybutadiene-polyol compound and the isocyanate group-containing (meth)acrylate compound used in the reaction cannot unequivocally be predetermined, since at least the number of hydroxyl groups of the hydrogenated polybutadiene-polyol compound and other conditions vary. However, about 1 (relative amount of substance) of a hydrogenated polybutadiene polyol compound is used with respect to about 2.1 (relative amount of substance) of an isocyanate group-containing (meth)acrylate compound.

Meanwhile, when the aforementioned reaction product contained in the composition of the present invention, i.e., a hydrogenated polybutadiene compound having a (meth)acrylic group; has an increased viscosity, preferably, the below-described ethylenic unsaturated monomer may be fed to the reaction container, and the reaction components may be allowed to react in the ethylenic unsaturated monomer, to thereby yield the aforementioned reaction product.

In the present invention, the hydrogenated polybutadiene compound having a (meth)acrylic group is suitably a compound represented by the following formula (1): 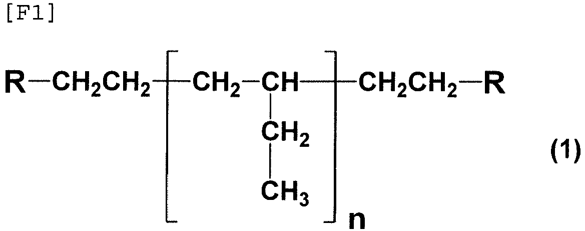 (wherein R represents a group represented by formula (2), and n is a natural number showing the number of recurring units).

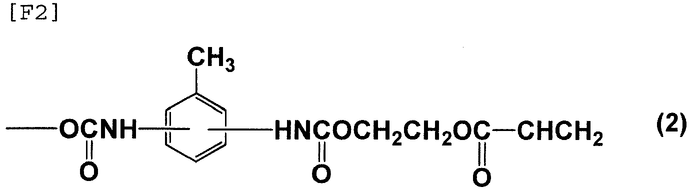

The hydrogenated polybutadiene compound having a (meth)acrylic group represented by the above formula (1) generally has a viscosity at 45°C of about 500 to about 4,000 P, preferably about 800 to about 3,200 P, more preferably about 1,000 to about 3,000 P.

Also, the hydrogenated polybutadiene compound having a (meth)acrylic group represented by the above formula (1) generally has an acrylic equivalent of about 500 to about 2,500 g/eq, preferably about 800 to about 2,300 g/eq, more preferably about 1,000 to about 2,100 g/eq.

The hydrogenated polybutadiene compound having a (meth)acrylic group represented by the above formula (1) may be produced through any of the aforementioned procedures, or may be available as a commercial product. Examples of such a commercial product include TEAI-1000 (product of Nippon Soda Co. Ltd.).

The composition of the present invention contains a radical polymerization initiator.

The radical polymerization initiator may be a radiation radical polymerization initiator or a thermal radical polymerization initiator.

Specific examples of the radiation radical polymerization initiator include α-diketones such as diacetyl; acyloins such as benzoin; acyloin ethers such as benzoin methyl ether, benzoin ethyl ether, and benzoin isopropyl ether; benzophenones such as thioxanthone, 2,4-diethylthioxanthone, thioxanthone-4-sulfonic acid, benzophenone, 4,4'-bis(dimethylamino)benzophenone, and 4,4'-bis(diethylamino)benzophenone; acetophenones such as acetophenone, p-dimethylaminoacetophenone, α,α-dimethoxy-α-acetoxyacetophenone, α,α-dimethoxy-α-phenylacetophenone, p-methoxyacetophenone, 1-[2-methyl-4-methylthiophenyl]-2-morpholino-1-propanone, 2-methyl-1-(4-methylthiophenyl)-2-morpholinopropan-1-one, and 2-benzyl-2-dimethylamino-1-(4-morpholinophenyl)butan-1-one; quinones such as anthraquinone and 1,4-naphthoquinone; halogen compounds such as phenacyl chloride, tribromomethyl phenyl sulfone, and tris(trichloromethyl)-s-triazine; bisimidazoles such as [1,2'-bisimidazole]-3,3',4,4'-tetraphenyl and [1,2'-bisimidazole]-1,2'-dichlorophenyl-3,3',4,4'-tetraphenyl; peroxides such as di-tert-butyl peroxide; and acylphosphine oxides such as 2,4,6-trimethylbenzoyldiphenylphosphine oxide.

Commercial products of the radiation radical polymerization initiator include Irgacur 127, 184, 369, 379EG, 651, 500, 907, CGI369, and CG24-61, Lucirin TPO, and Darocure 1116 and 1173 (trade names, products of BASF), and Ubecryl P36 (trade name, product of UCB).

Examples of the thermal radical polymerization initiator include a hydrogen peroxide, an azo compound, and a redox-type initiator.

Specific examples of the hydrogen peroxide include t-butyl(3,5,5-trimethylhexanoyl) peroxide, t-butyl hydroperoxide, cumene hydroperoxide, t-butyl peroxyacetate, t-butyl peroxybenzoate, t-butyl peroxyoctanoate, t-butyl peroxyneodecanoate, t-butyl peroxyisobutyrate, lauroyl peroxide, t-amyl peroxypivalate, t-butyl peroxypivalate, dicumyl peroxide, benzoyl peroxide, potassium persulfate, and ammonium persulfate.

Specific examples of the azo compound include dimethyl 2,2'-azobis(2-methylpropionate), 2,2'-azobis(isobutyronitrile), 2,2'-azobis(2-butanenitrile), 4,4'-azobis(4-pentanoic acid), 1,1'-azobis(cyclohexanecarbonitrile), 2-(t-butylazo)-2-cyanopropane, 2,2'-azobis[2-methyl-N-(1,1)-bis(hydroxymethyl)-2-hydroxyethyl]propionamide, 2,2'-azobis(2-methyl-N-hydroxyethyl)propionamide, 2,2'-azobis(N,N'-dimethyleneisobutylamidine) dichloride, 2,2'-azobis(2-amidinopropane) dichloride, 2,2'-azobis(N,N-dimethyleneisobutylamide), 2,2'-azobis(2-methyl-N-[1,1-bis(hydroxymethyl)-2-hydroxyethyl]propionamide), 2,2'-azobis(2-methyl-N-[1,1-bis(hydroxymethyl)ethyl]propionamide), 2,2'-azobis[2-methyl-N-(2-hydroxyethyl)propionamide), and 2,2'-azobis(isobutylamide) dihydrate.

Specific examples of the redox-type initiator include a mixture of a peroxide (e.g., hydrogen peroxide, an alkyl peroxide, a peracid ester, or a percarbonate salt) and an iron salt, a titanous salt, a zinc formaldehyde sulfoxylate, a sodium formaldehyde sulfoxylate, or a reducing sugar. Examples further include a mixture of an alkali metal salt of a persulfuric acid, a perboric acid, or a perchloric acid, ammonium perchlorate, with an alkali metal bisulfite such as sodium metabisulfite or a reducing sugar. Examples further include a mixture of an alkali metal persulfate with an arylsulfonic acid such as benzenesufonic acid, a reducing sugar, or the like.

Commercial products of the thermal radical polymerization initiator which may be employed in the present invention include Perhexa HC (product of NOF Corporation) and MAIB (dimethyl 2,2'-azobis(2-methylpropionate), product of Tokyo Chemical Industry Co., Ltd.).

In the case where the composition of the present invention contains a radical polymerization initiator, the radical polymerization initiator content of the composition is preferably 0.1 to 50 parts by mass, more preferably 1 to 30 parts by mass, still more preferably 2 to 30 parts by mass, with respect to 100 parts by mass of the hydrogenated polybutadiene compound having a (meth)acrylic group, from the viewpoints of suppression of radical deactivation by oxygen, ensuring storage stability, etc.

Notably, the above radical polymerization initiators may be used singly or in combination of two or more species. When the composition of the present invention contains both a radiation radical polymerization initiator and a thermal radical polymerization initiator, in one possible mode, only a UV-exposed portion of the pattern is cured in the presence of a radiation radical polymerization initiator, and after development, unreacted ethylenic unsaturated double bonds in the cured product are reacted by use of a thermal radical polymerization initiator.

The composition of the present invention may further contain, in combination with the radical polymerization initiator, a hydrogen-donor compound such as mercaptobenzothiazole and mercaptobenzoxazole, or a radiation sensitizer.

The composition of the present invention may further contain a solvent.

The solvent used in the present invention can uniformly dissolve the hydrogenated polybutadiene compound having a (meth)acrylic group and the below-described ingredients and is inert to these components.

Specific examples of such solvents include the solvents employed in production of the aforementioned reaction products, carbonate esters such as ethylene carbonate and propylene carbonate; carboxylic acids such as caproic acid and caprylic acid; alcohols such as 1-octanol, 1-nonanol, and benzyl alcohol; polyol alkyl ethers such as ethylene glycol monoethyl ether, diethylene glycol monomethyl ether, and propylene glycol monomethyl ether (PGME); polyol alkyl ether acetates such as ethylene glycol ethyl ether acetate and propylene glycol monomethyl ether acetate; esters such as ethyl 3-ethoxypropionate, methyl 3-methoxypropionate, ethyl 2-hydroxypropionate, and ethyl lactate; ketone alcohols such as diacetone alcohol; γ-butyrolactone; and phenyl cellosolve acetate. These solvents may be used singly or in combination or two or more species.

When the composition of the present invention contains a solvent, the solvent content is about 5 to about 30 mass%, with respect to the total amount of the composition.

The composition of the present invention may further contain an ethylenic unsaturated monomer, for improving adhesion of the thin film to the substrate and other reasons.

The ethylenic unsaturated monomer is a compound having at least one ethylenic unsaturated double bond, and examples thereof include a mono-function (meth)acrylate, a bi-function (meth)acrylate, and ≥3-function (meth)acrylate.

Of these, a mono-function (meth)acrylate is preferred from the viewpoint of improvement of adhesion to the substrate, with an alkyl mono-function (meth)acrylate being more preferred, and C≥6 alkyl mono(meth)acrylates being still more preferred.

The alkyl group may be any of linear-chain, branched-chain, and cyclic. Specific examples include C1 to C20 linear or branched alkyl groups such as methyl, ethyl, n-propyl, isopropyl, n-butyl, isobutyl, s-butyl, t-butyl, n-pentyl, n-hexyl, n-heptyl, n-octyl, n-nonyl, and n-decyl; and C3 to C20 cyclic alkyl groups such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl, and bicyclodecyl.

Specific examples of the C≥6 mono-function alkyl (meth)acrylate include hexyl (meth)acrylate, 2-ethylhexyl (meth)acrylate, heptyl (meth)acrylate, octyl (meth)acrylate, isooctyl(meth)acrylate, nonyl (meth)acrylate, isononyl (meth)acrylate, decyl (meth)acrylate, isodecyl (meth)acrylate, dodecyl (meth)acrylate, stearyl (meth)acrylate, isostearyl (meth)acrylate, lauryl (meth)acrylate, cyclohexyl (meth)acrylate, isobornyl (meth)acrylate, isoamyl (meth)acrylate, dicyclopentenyl (meth)acrylate, and tricyclodecanyl (meth)acrylate.

Of these, isodecyl (meth)acrylate, lauryl (meth)acrylate, cyclohexyl (meth)acrylate, isostearyl (meth)acrylate, and 2-ethylhexyl (meth)acrylate are preferably used.

Specific examples of mono-function (meth)acrylates other than the C≥6 mono-function alkyl (meth)acrylate include methyl (meth)acrylate, ethyl (meth)acrylate, phenoxyethyl (meth)acrylate, glycerin mono(meth)acrylate, glycidyl (meth)acrylate, n-butyl (meth)acrylate, benzyl (meth)acrylate, phenol ethylene oxide-modified (n=2) (meth)acrylate, nonylphenol propylene oxide-modified (n=2.5) (meth)acrylate, 2-(meth)acryloyloxyethyl acid phosphate, furfuryl (meth)acrylate, carbitol (meth)acrylate, benzyl (meth)acrylate, butoxyethyl (meth)acrylate, allyl (meth)acrylate, 2-hydroxyethyl (meth)acrylate, 2-hydroxypropyl (meth)acrylate, 2-hydroxybutyl (meth)acrylate, 2-phenoxy-2-hydroxypropyl (meth)acrylate, 2-hydroxy-3-phenoxypropyl (meth)acrylate, and 3-chloro-2-hydroxypropyl(meth)acrylate. Among them, a hydroxyl group-free mono-function (meth)acrylate is preferred, or such a (meth)acrylate having a molecular weight of about 100 to about 300 is also preferred.

Examples of the bi-function (meth)acrylate include ethylene glycol di(meth)acrylate, diethylene glycol di(meth)acrylate, tetraethylene glycol di(meth)acrylate, polyethylene glycol di(meth)acrylate, propylene glycol di(meth)acrylate, dipropylene glycol di(meth)acrylate, polypropylene glycol di(meth)acrylate, butylene glycol di(meth)acrylate, neopentyl glycol di(meth)acrylate, ethylene oxide-modified bisphenol A di(meth)acrylate, propylene oxide-modified bisphenol A di(meth)acrylate, 1,6-hexanediol di(meth)acrylate, glycerin di(meth)acrylate, pentaerythritol di(meth)acrylate, ethylene glycol diglycidyl ether di(meth)acrylate, diethylene glycol diglycidyl ether di(meth)acrylate, phthalic acid diglycidyl ester di(meth)acrylate, and hydroxypyvalic acid-modified neopentyl glycol di(meth)acrylate.

Examples of the ≥3-function (meth)acrylate include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tri(meth)acryloyloxyethoxytrimethylolpropane, and glycerin polyglycidyl ether poly(meth)acrylate.

These ethylenic unsaturated monomers may be used singly or in combination of two or more species.

When the composition of the present invention contains an ethylenic unsaturated monomer, the ratio by mass, hydrogenated polybutadiene compound having a (meth)acrylic group : ethylenic unsaturated monomer, is preferably 2 : 98 to 95 : 5, more preferably 20 : 80 to 80 : 20, for the purpose of producing a thin film having favorable adhesion at high reproducibility.

The composition of the present invention may further contain a polar group-containing monomer which can copolymerize with the aforementioned ethylenic unsaturated monomers, for enhancing adhesion to a substrate, heat resistance, etc.

Specific examples of the polar group-containing monomer include a monomer having a carboxyl group (e.g., (meth)acrylic acid), an acid anhydride monomer (e.g., maleic anhydride), a monomer having a hydroxyl group (e.g., 2-hydroxyethyl (meth)acrylate), a monomer having a sulfonate group (e.g., styrenesulfonic acid), a monomer having a phosphate group (e.g., 2-(meth)acryloyloxyethyl dihydrogen phosphate), a monomer having an amido group (e.g., 4-acryloylmorpholine), a monomer having an amino group (e.g., aminoethyl (meth)acrylate), a monomer having a glycidyl group (e.g., glycidyl (meth)acrylate), a monomer having a cyano group (e.g., acrylonitrile), and a vinyl monomer having a heterocyclic group (e.g., N-vinylpyridine).

When the composition of the present invention contains a polar group-containing monomer, the content does not generally exceed 1 mol with respect to 1 mol of the ethylenic unsaturated monomer.

In order to enhance coatability, defoaming property, leveling property, and other properties, the composition of the present invention may further contain a surfactant.

Specific examples of the surfactant include commercial fluorine-containing surfactants and silicone surfactants such as BM-1000 and BM-1100 (products of BM Chemie), Megafac F142D, F172, F173, F183, and F570 (products of DIC); Fluorad FC-135, FC-170C, FC-430, and FC-431 (products of Sumitomo 3M Ltd.); Surflon S-112, S-113, S-131, S-141, and S-145 (products of Asahi Glass Co., Ltd.); and SH-28PA, -190, -193, SZ-6032, and SF-8428 (products of Toray Dow Corning Silicone).

When the composition of the present invention contains a surfactant, the surfactant content is preferably 5 mass% or lower, with respect to the entire amount of the composition, for preventing deposition thereof from the cured film.

The composition of the present invention may further contain a thermal polymerization inhibitor.

Specific examples of the thermal polymerization inhibitor include pyrogallol, benzoquinone, hydroquinone, methylene blue, tert-butyl catechol, hydroquinone monobenzyl ether, methylhydroquinone, amylquinone, amyloxyhydroquinone, n-butylphenol, phenol, hydroquinone monopropyl ether, 4,4'-(1-methylethylidene)bis(2-methylphenol), 4,4'-(1-methylethylidene)bis(2,6-dimethylphenol), 4,4'-[1-[4-(1-(4-hydroxyphenyl)-1-methylethyl)phenyl]ethylidene]bisphenol, 4,4',4"-ethylidenetris(2-methylphenol), 4,4',4"-ethylidenetrisphenol, and 1,1,3-tris(2,5-dimethyl-4-hydroxyphenyl)-3-phenylpropane.

When the composition of the present invention contains a thermal polymerization inhibitor, the inhibitor content is preferably 5 mass% or lower, with respect to the entire amount of the composition, for preventing an excessive drop in radical polymerization performance and ensuring suitable radical polymerization performance.

For the purpose of tuning of the solubility of the composition in a developer and for other reasons, the composition of the present invention may contain an acid or an acid anhydride. Specific examples of the acid and acid anhydride include monocarboxylic acids such as acetic acid, propionic acid, n-butyric acid, iso-butyric acid, n-valeric acid, iso-valeric acid, benzoic acid, and cinnamic acid; hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid, and syringic acid; polybasic carboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxyliic acid, trimellitic acid, pyromellitic acid, cyclopentanetetracarboxylic acid, butanetetracarboxylic acid, and 1,2,5,8-naphthalenetetracarboxylic acid; acid anhydrides such as itaconic anhydride, succinic anhydride, citraconic anhydride, dodecenylsuccinic anhydride, tricarbanilic anhydride, maleic anhydride, hexahydrophthalic anhydride, methyltetrahydrophthalic anhydride, hymic anhydride, 1,2,3,4-butanetetracarboxlic dianhydride, cyclopentanetetracarboxlic dianhydride, phthalic anhydride, pyromellitic anhydride, trimellitic anhydride, benzophenonetetracarboxylic anhydride, ethylene glycol bis trimellitate anhydride, and glycerin tristrimellitate anhyderide.

In order to enhance the peeling removal property of the composition of the present invention, the composition may further contain a remover.

As the remover, any of a wax-type compound, a silcone compound, and a fluorine-containing compound may be used in the present invention. Among them, silicone compounds (silicone oil having a siloxane skeleton, emulsion, etc.) are preferred, by virtue of excellent heat resistance, moisture resistance, and stability over time.

The remover is available as a commercial product. Examples of such commercial products include Shin-Etsu Silicone (registered trademark) KF-96-10CS, KF-6012, X-22-2426, and X-22-164E (products of Shin-Etsu Chemical Co., Ltd.), TEGO RAD 2200N and TEGO RAD 2700 (products of Evonik), and BYK-333 (product of BYK Japan K.K.).

When the composition of the present invention contains a remover, the remover content is preferably 5 mass% or lower, with respect to the entire amount of the composition, for preventing deposition thereof from the cured film.

In order to enhance coatability of the composition, the composition of the present invention may further contain a thixotropy-imparting agent.

Specific examples of the thixotropy-imparting agent include commercial products of hydrophilic/hydrophobic fumed silica such as Aerosil 200, Aerosil RX200, and Aerosil RY200 (products of Nippon Aerosil Co., Ltd.), and commercial products of modified urea resins such as BYK-405, BYK-410, and BYK-411 (products of BYK Japan K.K.).

These thixotropy-imparting agents may be used singly or in combination of two or more species.

When the composition of the present invention contains a thixotropy-imparting agent, the thixotropy-imparting agent content is preferably 0.1 to 10 parts by mass, more preferably 1 to 6 parts by mass, with respect to 100 parts by mass of the composition, for maintaining hydrofluoric acid barrier property and adhesion to a substrate and enhancing coatability.

The composition of the present invention may contain a gelling agent for the following reason.

Specifically, in one possible technique for increasing the thickness of the resin thin film obtained from the composition of the present invention, the solid (e.g., a hydrogenated polybutadiene compound having a (meth)acrylic group) content of the resin composition is elevated, to thereby increase the amount of the component remaining after baking. On the other hand, when the solid content is elevated, the viscosity of the composition increases, whereby coatability is impaired, to possibly cause problems such as coating failure.

The gelling agent induces gelation in a gelling step (a prebake step) or another step after application of the composition, to thereby maintain a thick film. Thus, incorporation of the gelling agent can provide a composition which has high solid content but low viscosity and which is gelled in, for example, a prebake step before exposure to UV light. As a result, the thickness of the film can increase.

When the composition of the present invention contains a gelling agent, the viscosity of the composition decreases in a prebake step, to thereby enhance the uniformity in thickness of the coating film. When the composition is cooled to room temperature after prebaking, a solid gel of the composition is formed. As a result, substrate conveyance performance and the like can be advantageously facilitated.

No particular limitation is imposed on the gelling agent, any gelling agent may be used, so long as the gelling agent can induce gelation of the composition at room temperature and imparts such a thermally reversible property to the composition that the thus-formed gel is heated to be transformed into a liquid (sol) with flowability, and the sol is returned to the gel again by cooling. A typical example of the gelling agent is an oil gelling agent (an oily gelling agent).

Notably, the term gelation refers to such a phenomenon that a liquid loses flowability to form a solid which does not collapse by its own weight.

Specific examples of the oily gelling agent include an amino acid derivative, a long-chain fatty acid, a long-chain fatty acid polyvalent metal salt, a saccharide derivative, and a wax. Of these, an amino acid derivative and a long-chain fatty acid are preferred, from the viewpoints of coatability and other factors.

Specific examples of the amino acid derivative include C2 to C15 amino acids in which an amino acid group is acylated and C2 to C15 amino acids in which a carboxylate group is esterified or amidized. Examples thereof include N-lauroyl-L-glutamate di(cholesteryl/beheynl/octyldodecyl), N-lauroyl-L-glutamate di(cholesteryl/octyldodecyl), N-lauroyl-L-glutamate di(phitosteryl/behenyl/octyldodecyl), N-lauroyl-L-glutamate di(phitosteryl/octyldodecyl), dibutylamide N-lauroyl-L-glutamate, and dibutylamide N-ethylhexanoyl-L-glutamate.

Specific examples of the long-chain fatty acid include C8 to C24 saturated or unsaturated fatty acids and homologous of the long-chain fatty acid, e.g., 12-hydroxystearic acid. Specific examples of the saturated fatty acid include octanoic acid, 2-ethylhexanoic acid, decanoic acid, lauric acid, myristic acid, stearic acid, palmitic acid, arachidic acid, and behenic acid. Specific examples of the unsaturated fatty acid include palmitoleinic acid, oleic acid, veccenic acid, linoleic acid, linolenic acid, arachdonic acid, icosadienic acid, and erucic acid.

Specific examples of the long-chain fatty acid metal salt include metal salts of the aforementioned long-chain fatty acids. In the case of a C18-chain saturated fatty acid, specific examples include aluminum stearate, magnesium stearate, manganese stearate, iron stearate, cobalt stearate, calcium stearate, and lead stearate.

Specific examples of the saccharide derivative include dextrin fatty acid esters such as dextrin laurate, dextrin myristate, dextrin palmitate, dextrin margarate, dextrin stearate, dextrin arachate, dextrin lignocerate, dextrin cerotate, dextrin 2-ethylhexanoate palmitate, and dextrin palmitate stearate; sucrose fatty acid esters such as sucrose palmitate, sucrose stearate, and sucrose acetate/stearate; oligofructose fatty acid esters such as oligofructose stearate and oligofructose 2-ethylhexanoate; and sorbitol benzylidene derivatives such as monobenzylidene sorbitol and dibenzylidene sorbitol.

Among them, those having a melting point of 70 to 100°C; e.g., 12-hydroxystearic acid (m.p.: 78°C) and dextrin palmitate (m.p.: 85 to 90°C), are preferred.

The aforementioned gelling agents may be used singly or in combination of two or more species.

The gelling agent of the present invention may be used as a powder, a liquid, or a solution.

The gelling agent solution is prepared by dissolving the gelling agent in powder (or liquid) form in a conventional organic solvent such as ethanol or PGME.

Notably, ethanol and PGME inhibit formation of a hydrogen bond of a gelling agent in the composition, to thereby suppress gelation of the composition.

When the composition of the present invention contains a gelling agent, the gelling agent content is preferably 0.1 to 30 parts by mass, more preferably 3 to 10 parts by mass, with respect to 100 parts by mass of the composition, for maintaining hydrofluoric acid barrier property and adhesion to a substrate and enhancing coatability.

In the case where the gelling agent is a solid, the gelling agent is thermally melted at a prebake step (e.g., 80°C to 110°C) before exposure to UV light, and uniformly incorporated into the composition. After cooling, the composition becomes a gel. In the case where the gelling agent is a solution, the organic solvent vaporizes at a prebake step, whereby the gelling agent concentration relatively increases. In another mechanism, the organic solvent, which impedes the interaction of the gelling agent, is removed, and the composition becomes a gel after cooling the composition.

In order to enhance compatibility of other ingredients with the gelling agent and to suppress monomer-monomer separation, monomer-organic solvent separation, and the like, the composition of the present invention may further contain an emulsifying agent.

In the case where the gelling agent in powder form is used, uniform dispersion of the gelling agent in the composition is facilitated by virtue of the emulsifying agent. In the case where the solution of the gelling agent in an organic solvent is used, the emulsifying agent facilitates prevention of separation of the gelling agent from the composition.

Examples of the emulsifying agent which may be used in the present invention include modified silicone oils such as Shin-Etsu Silicone (registered trademark) KF-640, KF-6012, and KF-6017 (products of Shin-Etsu Chemical Co., Ltd.) and polyoxyethylene alkyl ethers such as Pegnol O-20, Pegnol 16A, and Pegnol L-9A (products of Toho Chemical Industry Co., Ltd.).

Among them, a modified silicone oil is preferred, since it can serve as a remover and an emulsifying agent.

The performance of the emulsifying agent is represented by a parameter HLB (hydrophile-lipophile balance). In the case of a substance having no hydrophilic group, HLB is 0, whereas in the case of a substance having only a hydrophilic group but no oleophilic group, HLB is 20. That is, the emulsifying agent has an HLB of 0 to 20.

In the present invention, a suitable HLB value is appropriately predetermined, in consideration of the type, amount, and the like of the gelling agent used therewith.

When the composition of the present invention contains an emulsifying agent, the emulsifying agent content is preferably 5 mass% or lower, with respect to the entire amount of the composition, for preventing deposition thereof from the cured film.

In addition, the composition of the present invention may further contain other ingredients such as a leveling agent.

The composition of the present invention can be prepared by mixing the ingredients such as a hydrogenated polybutadiene compound having a (meth)acrylic group and a solvent.

In one mode of kneading, required amounts of the raw materials are fed to an SUS preparation tank equipped with agitation paddles, and the mixture is kneaded at room temperature to a uniform composition.

More specifically, a composition containing a polymerization initiator and the thixotropy-imparting agent may be prepared through the following procedure.

Firstly, low-viscosity materials which readily receive a thixotropic property including the ethylenic unsaturated monomer and a solvent are mixed with the thixotropy-imparting agent by means of a high-shear mixer such as a disper, to thereby prepare a mixture having a strong thixotropic property. Then, materials including the hydrogenated polybutadiene compound having a (meth)acrylic group, except for the polymerization initiator, are added to the mixture and uniformly dispersed in the gel by means of a high-shear mixer. Finally, the polymerization initiator is added thereto, and the mixture is kneaded by means of a low-speed mixer such as a triple roll mill, to thereby preparer a uniform mixture.

Through this mixing procedure, a considerably further uniform composition can be prepared, and decomposition of the polymerization initiator, which would otherwise be caused by heat generated in agitation by means of a high-shear mixer, can be avoided.

Basically, the composition containing a gelling agent can be prepared through the same procedure as employed above, so long as heating to impair the gel-formation property of the gelling agent is prevented.

As described above, the composition of the present invention can be prepared by mixing the ingredients. If required, the resultant composition may be filtered through a mesh, a membrane filter, or the like.

In the case where a certain ingredient of the composition also serves as another ingredient of the composition, the amounts of ingredients must be adjusted in consideration thereof.

The aforementioned composition of the present invention is applied onto a glass substrate, a substrate having an insulating film (e.g., SiO₂ or SiN), or a similar substrate, and the substrate is optionally heated, whereby the resin thin film for use in hydrofluoric acid etching can be formed.

Examples of the application method which may be employed in the invention include spin coating, slit coating, roller coating, screen printing, or applicator coating.

Heating conditions cannot be unequivocally predetermined, since they vary in accordance with the type and amount(s) of the component(s) in the composition, the thickness of coating film, and other factors. In general consideration of adhesion of film to a substrate during etching, peelability of film from the substrate after etching, etc., the heating temperature is generally 40 to 160°C, preferably 60 to 120°C, and the heating time is generally about 3 to about 15 minutes.

The thickness of the resin thin film is preferably 5 to 150 µm, more preferably 10 to 50 µm, from the viewpoints of realizing, at high reproducibility, properties such as hydrofluoric acid resistance, peeling resistance, etc.

The film thickness may be modulated by, for example, varying the solid content of the composition or the application amount onto the substrate.

Hereinafter, an example of the method for producing a patterned substrate by use of the composition of the present invention will be described.

Firstly, the resin thin film of the present invention is formed on a substrate through the aforementioned method.

Then, the thus-obtained resin thin film is exposed, via a photomask having a pattern of interest, to radiation, for example, UV radiation having a wavelength of 300 to 500 nm or visible light, whereby the exposed portion is cured.

In the present invention, the term "radiation" refers to a UV radiation, visible light, far-UV radiation, an X-ray, an electron beam, or the like. Examples of the light source which may be used in the present invention include a low-pressure mercury lamp, a high-pressure mercury lamp, an ultra-high-pressure mercury lamp, a metal halide lamp, a UV-LED, and an argon gas laser.

The dose of radiation cannot unequivocally be predetermined, since it varies in accordance with the type and amount(s) of the component(s) in the composition, the thickness of coating film, and other factors. However, when a high-pressure mercury lamp is used, the dose is about 100 to about 1,500 mJ/cm².

Subsequently, development is performed by use of a developer, whereby at least an unneeded non-exposed portion is dissolved and removed. As a result, the exposed portion and other necessary portions are selectively left, whereby a cured film having a target pattern (i.e., a cured resin thin film) is produced.

Typically, an aqueous alkaline solution or an organic solvent can be used as as a developer.

Examples of the aqueous alkaline solution serving as a developer include aqueous solutions of alkali compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene, and 1,5-diazabicyclo[4.3.0]-5-nonane. To any of the aqueous alkali solutions, an appropriate amount of an aqueous organic solvent such as methanol or ethanol and/or a surfactant may be added, to thereby provide an alternative developer.

No particular limitation is imposed on the organic solvent for use in the developer, so long as it can favorably dissolve the resin thin film of the present invention. Examples of the organic solvent include aromatic compounds such as toluene and xylene; aliphatic compounds such as n-hexane, cyclohexane, and isoparaffin; ether compounds such as tetrahydrofuran; ketone compounds such as methyl ethyl ketone and cyclohexanone; ester compounds such as acetate esters; and halogen compounds such as 1,1,1-trichloroethane. Notably, in order to adjust development rate, the above organic solvents may further contain an appropriate amount of a solvent which cannot dissolve the resin thin film of the present invention such as ethanol or isopropanol.

The development time cannot unequivocally be predetermined, since it varies in accordance with the type and amount(s) of the component(s) in the composition, the thickness of coating film, and other factors. However, the time is generally 30 to 1,000 seconds.

Also, any development method may be employed, the method including dipping, the paddle method, spraying, and shower developing.

After development, the remaining resin pattern is washed with a flow of water for about 30 to about 90 seconds, and dried through air blowing by means of a spin drier or an air gun, or through heating on a hot plate, in an oven, or by another means.

Meanwhile, the resin thin film of the present invention can be satisfactorily cured through the aforementioned irradiation alone. However, the resin thin film may be cured to a further extent through additional irradiation (hereinafter referred to as "post light exposure") or heating.

The post light exposure may be performed in the same manner as employed in the aforementioned radiation procedure, and the dose is about 100 to about 2,000 mJ/cm², when a high-pressure mercury lamp is employed.

In one heating procedure for further curing the resin thin film, the film is heated by means of a heating apparatus such as a hot plate or an oven, at 60 to 150°C for 5 to 60 minutes.

Through such a further curing process, patterning precision in development can be conceivably attained.

Next, the substrate having a target pattern formed from the cured film is subjected to etching.

Etching may be performed through various conventional techniques. Specific examples of such techniques include wet etching, chemical etching under reduced pressure (i.e., dry etching), and a combination thereof.

Examples of the etchant which may be used in wet etching include hydrofluoric acid, a mixture of hydrofluoric acid and ammonium fluoride, and an acid mixture of hydrofluoric acid and another acid (e.g., hydrochloric acid, sulfuric acid, or phosphoric acid). In dry etching, CF gas or the like may be used.

Eventually, the cured film is removed from the substrate.

Examples of the removing technique include immersing the substrate in a remover liquid and physically (e.g., manually) removing from the substrate (i.e., peeling).

Examples of the remover include inorganic alkalis such as sodium hydroxide and potassium hydroxide; tertiary amines such as trimethanolamine, triethanolamine, and dimethylaniline; and organic alkalis (quaternary ammoniums) such as tetramethylammonium hydroxide and tetraethylammonium hydroxide, and examples of the solvent include water, dimethyl sulfioxide, N-methylpyrrolidone, and a mixture thereof.

Alternatively, when an aromatic hydrocarbon (e.g., toluene, xylene, or limonene) or an aliphatic hydrocarbon is used as a remover, a cured film can be removed via swelling. Examples

The present invention will next be described in detail by way of examples, which should not be construed as limiting the invention thereto.

### (1) Preparation of compositions

### [Examples 1 to 12]

TEAI-1000 (product of Nippon Soda Co. Ltd., weight average molecular weight: 5,500) was used as a hydrogenated polybutadiene compound having a (meth)acrylic group (HPBD). Composition of Examples 1 to 12 were prepared from the ingredients at proportions by mass shown in Table 1.

**[Table 1]**

| | HPBD | Radiation radical polymn. intiator | | Solvent | | Ethylenic unsaturated monomers | | | | | | | Surfactant | Gelling agent |
|---|---|---|---|---|---|---|---|---|---|---|---|---|---|---|
| | TEAI-1000 | Irg. 127 | TPO | PGME | CHN | IBMA | LA | FA-513M | BzMA | ACMO | A-TMPT | A-DCP | F-570 | 12HSA |
| Ex. 1 | 100 | 5 | 2 | - | 20 | - | - | - | - | - | - | - | - | - |
| Ex. 2 | 80 | 5 | 2 | - | 20 | - | 20 | - | - | - | - | - | - | - |
| Ex. 3 | 40 | 5 | 2 | - | - | 60 | - | - | - | - | - | - | - | - |
| Ex. 4 | 40 | 5 | 2 | 20 | - | 60 | - | - | - | - | - | - | - | 5 |
| Ex. 5 | 30 | 5 | 2 | 20 | - | - | - | - | 32 | 32 | - | - | 0.5 | 5 |
| Ex. 6 | 30 | 5.5 | 2.2 | 22 | - | - | 27 | 43 | - | - | 10 | - | - | 5.5 |
| Ex. 7 | 30 | 4.7 | 1.9 | 18.8 | - | - | 16 | 32 | - | 16 | - | - | - | 4.7 |
| Ex. 8 | 30 | 5 | 2 | 20 | - | 70 | - | - | - | - | - | - | - | 5 |
| Ex. 9 | 30 | 5.5 | 2.2 | 22 | - | 43 | 27 | - | - | - | - | 10 | - | 5.5 |
| Ex. 10 | 30 | 5.5 | 2.2 | 22 | - | 43 | 27 | - | - | - | 10 | - | - | 5.5 |
| Ex. 11 | 30 | 5 | 2 | 20 | - | 32 | - | - | - | 32 | - | - | 0.5 | 5 |
| Ex. 12 | 20 | 5 | 2 | 20 | - | 80 | - | - | - | - | - | - | - | 5 |

| | | | | | | | | | | | | | | |
|---|---|---|---|---|---|---|---|---|---|---|---|---|---|---|
| TEAI-1000: hydrogenated polybutadiene with end acrylic group (Nippon Soda Co. Ltd.) IBMA: isobornyl methacrylate (Tokyo Chemical Industry Co., Ltd.) LA: lauryl acrylate (Tokyo Chemical Industry Co., Ltd.) FA-513M: dicyclopentanyl methacrylate (Hitachi Chemical Co., Ltd.) BzMA: benzyl methacrylate (Tokyo Chemical Industry Co., Ltd.) ACMO: 4-acryloylmorpholine (Tokyo Chemical Industry Co., Ltd.) A-TMPT: trimethylolproane triacrylate (Shin-Nakamura Chemical Co., Ltd.) A-DCP: tricyclodecanedimethanol diacrylate (Shin-Nakamura Chemical Co., Ltd.) 12HSA: 12-hydroxystearic acid (Tokyo Chemical Industry Co., Ltd.) PGME: 1-methoxy-2-propanol (Kyowa Hakko Chemical Co., Ltd.) CHN: cyclohexanone (Sankyo Chemical Co., Ltd.) Irg. 127: Irgacure 127 (BASF) TPO: Irgacure TPO (BASF) F-570: Megafac F-570 (DIC) | | | | | | | | | | | | | | |

### [Comparative Example 1]

The procedure (ingredients at proportions by mass) of Example 5 was repeated, except that UV-2750B (urethane acrylate resin, product of The Nippon Synthetic Chemical Industry Co., Ltd.) was used instead of TEAI-1000, to thereby prepare a composition of Comparative Example 1.

### (2) Production of cured film and evaluation of hydrofluoric acid (HF) resistance thereof

### [Examples 13 to 24 and Comparative Example 2]

Each of the compositions prepared in Examples 1 to 12 and Comparative Example 1 was applied onto a silicon substrate having a thermal oxide film (SiO₂ film thickness: 300 nm) thereon by means of an applicator. The coating film was baked at 110°C for 2 minutes by means of a hot plate and then cooled at room temperature for 2 minutes, to thereby form a resin thin film on the substrate.

Subsequently, the resin thin film was exposed to UV light (55 mW/cm², 999 mJ) and baked at 150°C for 5 minutes by means of a hot plate for curing, to thereby form a cured film. The thickness of the film was found to be 30 µm to 50 µm.

Thereafter, each of the substrates having a protective film produced was immersed in 9 mass% hydrofluoric acid-8 mass% sulfuric acid aqueous solution (hereinafter may be referred to as an etchant) at 25°C. Etching was conducted for 60 minutes under circulation of the etchant. Then, the substrate was washed with water, and the cured film was physically peeled from the substrate by hand. The thickness of thermal oxide film which had been covered with the cured film was measured by means of an ellipsometer (model M-2000, product of J. A. Woollam). In evaluation of hydrofluoric acid (HF) resistance, the case where the thickness of thermal oxide film was 290 nm or more is rated with "A," the case where the thickness was 200 nm or more and less than 290 nm is rated with "B," and the case where the thickness was less than 200 nm is rated with "C." Table 2 shows the results.

**[Table 2]**

| | HF resistance |
|---|---|
| Ex. 13 | B |
| Ex. 14 | A |
| Ex. 15 | A |
| Ex. 16 | A |
| Ex. 17 | A |
| Ex. 18 | B |
| Ex. 19 | B |
| Ex. 20 | A |
| Ex. 21 | B |
| Ex. 22 | B |
| Ex. 23 | A |
| Ex. 24 | A |
| Comp. Ex. 2 | C |

As is clear from Table 2, a film having excellent hydrofluoric acid resistance was yielded by use of the composition of the present invention, regardless of the presence of an ethylenic unsaturated monomer, a solvent, a gelling agent, a surfactant, etc. Also, each film was readily removed through peeling.

In contrast, when the composition of Comparative Example was used, removal of the film during etching was not observed. However, fluoric acid penetrated the film, resulting in corrosion of SiO₂.

## Claims

1. A resin-thin-film-forming composition employed in hydrofluoric acid etching, which composition comprises a hydrogenated polybutadiene compound having a (meth)acrylic group and a radical polymerization initiator.

2. A resin-thin-film-forming composition according to claim 1 employed in hydrofluoric acid etching, wherein, in the hydrogenated polybutadiene compound having a (meth)acrylic group, the (meth)acrylic group is bonded via urethane bonding.

3. A resin thin film for use in hydrofluoric acid etching produced by use of a resin-thin-film-forming composition as recited in claim 1 or 2.

4. A method for producing a patterned substrate, **characterized in that** the method comprises:
a step of forming a resin thin film for use in hydrofluoric acid etching on a substrate by use of a resin-thin-film-forming composition employed in hydrofluoric acid etching as recited in claim 1 or 2;
a step of curing the resin thin film; and
a step of patterning, through etching, the substrate on which the resin thin film for use in hydrofluoric acid etching has been formed.
